# FASCICULE DE BREVET EUROPEEN

(11) **EP 0 482 547 B1**
(45) Date de publication et mention de la délivrance du brevet: **03.01.1996**
(21) Numéro de dépôt: 91117913.3
(22) Date de dépôt: 21.10.1991
(51) Int. Cl.: H01H 33/26

(54) **Disjoncteur à détection d'arc**
Schalter mit Lichtbogenerfassung
Circuit breaker with arc detection

(30) Priorité: 22.10.1990 FR 9013049
(43) Date de publication de la demande: 29.04.1992
(73) Titulaire: GEC ALSTHOM SA, F-75116 Paris (FR)
(72) Inventeur: Pham, Van Doan, F-69330 Meyzieu (FR); Martin, Joseph, F-69330 Meyzieu (FR); Dupraz, Jean-Pierre, F-69003 Lyon (FR)
(74) Mandataire: Weinmiller, Jürgen

(56) Documents cités:
- EP-A- 0 382 134
- DE-A- 3 110 766
- DE-A- 3 337 553
- DE-A- 3 542 550
- FR-A- 2 640 386
- PATENT ABSTRACTS OF JAPAN vol. 14, no. 452 (P-1112)(4395), 27 septembre 1980; & JP-A-02181668 (FURUKAWA ELECTRIC CO. LTD.) 16.07.1990
- JOURNAL OF LIGHTWARE TECHNOLOGY vol. 7, no. 7, juillet 1989, p. 1029, New York, US; K. MUTO: "Elektric-Discharge Sensor Utilizing Fluorescent Optical Fiber"
- JOURNAL OF LIGHTWAVE TECHNOLOGY vol. 7, no. 7, juillet 1989, page 1029, New York, US; K. MUTO: "Electric-Discharge Sensor Utilizing Fluorescent Optical Fiber"

## Description

La présente invention concerne un disjoncteur dans lequel des moyens sont prévus pour détecter l'apparition d'un arc électrique, mesurer sa durée et évaluer l'intensité du courant correspondant.

La connaissance de tels paramètres permet d'apprécier l'usure des contacts et de vérifier le bon fonctionnement du disjoncteur. Une telle surveillance de l'état du disjoncteur permet de planifier la maintenance et de prévenir les défauts de fonctionnement.

L'invention est fondée sur l'utilisation de fibres fluorescentes. La Demanderesse, dans le brevet français 2.640 386 , a montré la possibilité d'utiliser des fibres optiques fluorescentes pour la détection des effluves lumineux, visibles ou non, dans les appareillages sous enveloppe métallique.

Il a été décrit, dans le document EP-A-O 382 134, un disjoncteur selon le préambule de la revendication 1 ci-après.

Un but de la présente invention est de réaliser un disjoncteur muni de moyens de détection d'arc, permettant de classer les arcs selon plusieurs plages d'intensité.

Ce but est atteint selon l'invention par le disjoncteur tel que défini par la revendication 1. En ce qui concerne des caractéristiques de certaines réalisations préférées d'un tel disjoncteur, référence est faite aux revendications dépendantes.

L'invention sera décrite ci-après plus en détail à l'aide de divers modes de mise en oeuvre en référence au dessin annexé dans lequel:
- la figure 1 est une vue schématique en élévation d'une phase d'un disjoncteur à une chambre de coupure par phase,
- la figure 2 illustre l'agencement d'une chambre avec deux fibres optiques,
- la figure 3 montre une variante de réalisation dans laquelle la fibre optique est protégée par un tube transparent,
- la figure 4 illustre une autre variante dans laquelle la fibre optique est placée à l'extérieur du support isolant de la chambre de coupure.

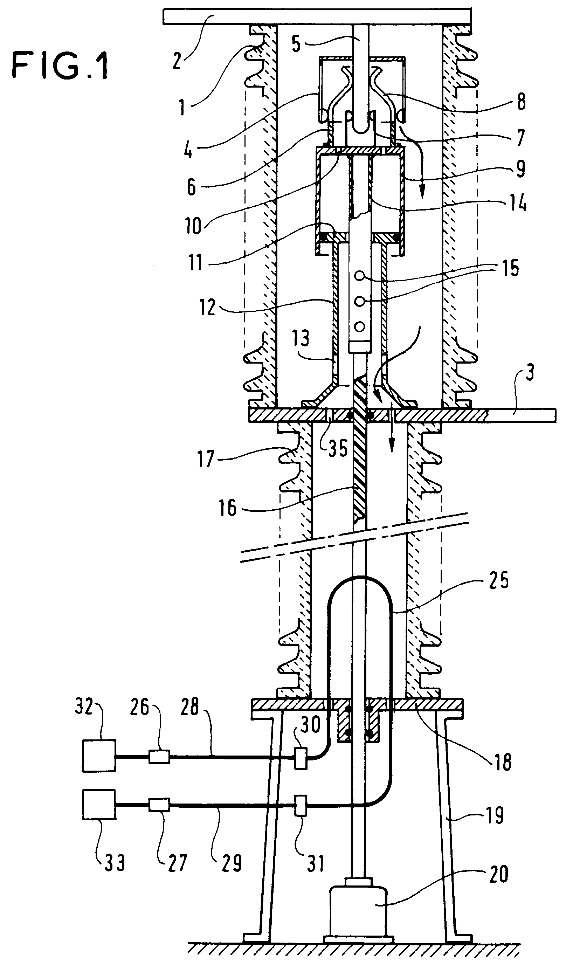

Dans la figure 1, la référence 1 désigne une enveloppe isolante délimitant une chambre de coupure d'un disjoncteur à une chambre de coupure par phase. L'enveloppe est fermée à son extrémité supérieure par une première plaque 2 constituant une première prise de courant et, à sa partie inférieure, par une seconde plaque constituant une seconde prise de courant 3.

A l'intérieur de la chambre de coupure, on trouve des doigts de contact 4 constituant le contact principal fixe, un contact d'arc fixe 5, un tube 6 constituant un contact principal mobile, des doigts de contact 7 constituant le contact d'arc mobile et une buse de soufflage 8.

Les contacts mobiles sont fixés à un cylindre mobile 9 ayant un fond percé d'orifices 10 pour le passage du gaz de soufflage de l'arc. Un piston 11 est fixé par un tube 12 à la plaque 3. Le tube 12 est percé de trous 13 pour la circulation du gaz. Le cylindre mobile 9 est fixé par son fond à un tube 14 percés de trous 15 et relié à une tige de manoeuvre 16, en matériau isolant.

La tige isolante traverse la plaque 3 et se prolonge à l'intérieur d'une colonne 17, en matériau isolant, servant de support à la chambre de coupure 1. La partie inférieure du support 17 est fermée de manière étanche par un fond 18 supporté par une structure métallique 19. La tige 16 traverse, de manière étanche, le fond 18, et est reliée à un mécanisme de manoeuvre 20.

La chambre 1 et le support 17 sont remplis de gaz diélectrique sous pression, par exemple de l'hexafluorure de soufre SF6.

Conformément à l'invention, une fibre fluorescente 25 est disposée à l'intérieur du support 17, de manière à constituer une boucle symétrique dont les deux brins traversent le fond 18, de manière étanche, et dont les extrémités sont reliées à des photo-diodes 26 et 27, soit directement, soit, comme montré dans la figure 1, au moyens de fibres plastiques transparentes 28, 29, associées à des éléments de connexion optiques 30 et 31. Les sorties des photo-diodes sont connectées à des amplificateurs 32, 33, de sensibilité différentes, par exemple dans un rapport de 2.

Le fonctionnement est le suivant:
- à l'ouverture du disjoncteur, par manoeuvre de la tige 16, le contact d'arc mobile 7 quitte le contact d'arc fixe 5; un arc jaillit entre ces contacts. Une onde lumineuse se transmet alors à travers le tube 14. Une grande partie des gaz chauds s'échappe par les ouvertures 15 et 13. La lumière traverse des trous 35, de faible diamètre, pratiqués dans la plaque 3. Le faible diamètre des trous 35 empêche le gaz chaud de pénétrer dans la colonne support 17, mais n'empêche pas la lumière d'y entrer. La fibre optique 25 capte, par sa surface latérale, l'onde lumineuse. La sensibilité de la mesure est élevée car l'onde est captée sur toute la longueur de la fibre, qui peut être de plusieurs dizaines de centimètres, et non sur une petite section comme ce serait le cas si on utilisait une fibre de silice. La forme symétrique donnée à la fibre permet d'assurer que chaque brin reçoit une égale quantité de lumière; on peut positionner la fibre avec précision en étalonnant l'appareil avec des amplificateurs 32 et 33 identiques. Le réglage étant fait, on choisira des amplificateurs de sensibilités différentes de manière à pouvoir classer les arcs selon deux plages d'intensité.

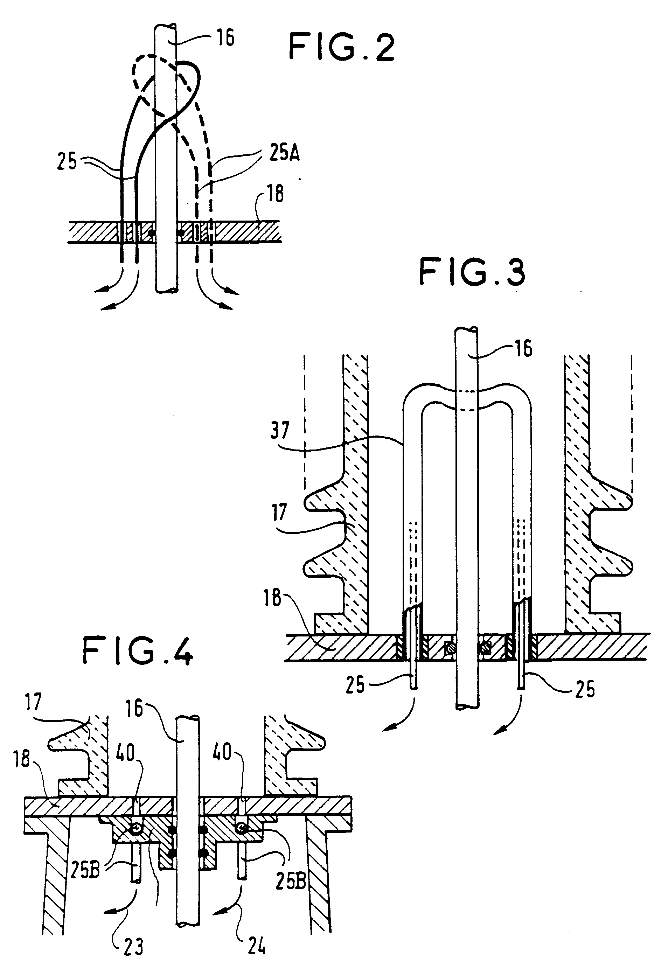

Dans la variante de réalisation représentée dans la figure 2, on utilise deux boucles symétriques entre elles 25 et 25 A, ce qui permet, avec des amplificateurs appropriés, de classer les arcs selon quatre plages d'intensité.

Dans la variante de réalisation de la figure 3, la fibre 25 se trouve à l'intérieur d'un tube transparent 37 placé à l'intérieur du support 17; le tube a de préférence la forme d'un U renversé. L'intérieur du tube est à l'air atmosphérique et est étanche au gaz diélectrique. Les deux branches du tube sont parallèles à la tige isolante 16. La partie haute du tube entoure la tige isolante 16. Cette disposition présente l'avantage de faciliter le remplacement de la fibre optique abîmée sans démontage de l'appareil et d'éviter de mettre la fibre fluorescente en contact avec le gaz diélectrique et les produits de décomposition dus à l'arc qui pourraient pénétrer dans le support 17 malgré les précautions prises pour l'éviter.

Dans la variante de réalisation de la figure 4, la fibre 25B est placée dans l'air atmosphérique, à l'extérieur du support 17; la plaque 18 est munie de plusieurs hublots transparents 40 de faible diamètre et étanches au gaz diélectrique.

La fibre 25B est placée derrière ces hublots dans une enceinte 41 fermée et obscure ; les deux extrémités de la fibre 25B sont reliées, comme précédemment, à des photo-diodes 23 et 24.

Les fibres optiques fluorescentes mentionnées plus haut peuvent, pour certaines applications, être remplacées par des fibres scintillantes.

On notera qu'il suffit que les trous 35 aient ensemble une surface de 1 centimètre carré pour que la lumière reçue par la fibre optique soit suffisante.

L'invention permet une mesure précise du nombre des arcs intervenant au cours du fonctionnement d'un disjoncteur; il est possible, avec une bonne précision de déterminer la durée de chaque arc à l'ouverture comme à la fermeture des contacts et les plages d'intensité correspondant à ces arcs, et de prévoir un plan de maintenance du disjoncteur et d'éviter les pannes inopinées. La fibre optique utilisée, placée loin des gaz chauds, fournit des valeurs précises et répétitives. Lors d'un mauvais fonctionnement entraînant une durée d'arc trop longue (non coupure à faible intensité par exemple), ce principe de détection permettra au système de protection de prendre des mesures adéquates afin de protéger l'installation.

L'invention s'applique aux disjoncteur de type à enveloppe céramique ainsi qu'aux disjoncteurs de type à enveloppe métallique; dans ce dernier cas, la fibre est montée dans la cuve monophasée, derrière la tige de manoeuvre.

## Revendications

1. Disjoncteur à haute tension comprenant, pour chaque phase, au moins une enveloppe (1) remplie de gaz diélectrique sous pression et comportant des contacts principaux fixes (4) et mobiles (6), des contacts d'arc fixes (5) et mobiles (7), et une tige de manoeuvre(16), ladite enveloppe isolante (1) étant placée sur une colonne isolante (17), une plaque métallique (3) constituant une prise de courant séparant ladite enveloppe (1) et ladite colonne isolante (17), ladite colonne isolante (17) étant fermée par un fond (18) disposé sur une structure métallique (19), ladite tige de manoeuvre (16) traversant ladite plaque (3) et ledit fond (18), ledit disjoncteur comprenant un détecteur du flux lumineux émis par les arcs survenant dans ladite enveloppe (1), caractérisé en ce que le détecteur du flux lumineux comporte une fibre fluorescente (25) qui est disposée en boucle symétrique autour de la tige de maneouvre (16), chacune des extrémités de la fibre étant reliée à une photo-diode (26, 27) équipée d'un amplificateur, lesdits amplificateurs étant de sensibilités différentes.

2. Disjoncteur selon la revendication 1, caractérisé en ce que la boucle (25) est disposée à l'intérieur de la colonne isolante (17), la plaque métallique (3) étant percée d'ouvertures (35).

3. Disjoncteur selon la revendication 2, caractérisé en ce qu'une seconde fibre fluorescente ou scintillante (25A) est montée symétriquement par rapport à la première fibre (25).

4. Disjoncteur selon l'une des revendications 1 à 3, caractérisé en ce que la fibre optique (25) est placée à l'intérieur d'un tube transparent (37) dans lequel est placé de l'air.

5. Disjoncteur selon la revendication 1, caractérisé en ce que ladite fibre optique (25B) est placée à l'extérieur de la colonne isolante (17), derrière le fond (18) muni de hublots transparents (40), la plaque métallique (3) étant percée d'ouvertures (35).

## Patentansprüche

1. Hochspannungs-Trennschalter, der für jede Phase mindestens eine Hülle (1) aufweist, die mit unter Druck stehendem dielektrischem Gas gefüllt ist und feste (4) und bewegliche Hauptkontakte (6), feste (5) und bewegliche Lichtbogenkontakte (7) und einen Betätigungsstab (16) enthält, wobei die Metallhülle (1) auf einer isolierenden Säule (17) sitzt und eine Metallplatte (3) einen Stromanschluß bildet, der die Hülle (1) und die isolierende Säule (17) voneinander trennt, wobei die isolierende Säule (17) von einem Boden (18) verschlossen wird, der auf einer Metallstruktur (19) angeordnet ist, wobei der Betätigungsstab (16) die Platte (3) und den Boden (18) durchquert, wobei der Trennschalter einen Detektor für den Lichtfluß aufweist, der von den Lichtbögen ausgesendet wird, die sich in der Hülle (1) ausbilden, dadurch gekennzeichnet, daß der Lichtfluß-Detektor eine fluoreszierende Faser (25) enthält, die in Form einer symmetrischen Schleife um den Betätigungsstab (16) angeordnet ist, und daß jedes Ende der Faser mit einer Fotodiode (26, 27) verbunden ist, die an einen Verstärker angeschlossen ist, wobei diese Verstärker unterschiedliche Empfindlichkeiten aufweisen.

2. Trennschalter nach Anspruch 1, dadurch gekennzeichnet, daß die Schleife (25) sich im Inneren der isolierende Säule (17) befindet und die Metallplatte (3) Öffnungen (35) aufweist.

3. Trennschalter nach Anspruch 2, dadurch gekennzeichnet, daß eine zweite fluoreszierende oder szintillierende Faser (25A) symmetrisch in Bezug auf die erste Faser (25) angeordnet ist.

4. Trennschalter nach einem der Ansprüche 1 bis 3, dadurch gekennzeichnet, daß die Lichtleitfaser (25) innerhalb eines durchsichtigen Rohrs (37) angeordnet ist, in dem sich Luft befindet.

5. Trennschalter nach Anspruch 1, dadurch gekennzeichnet, daß die Lichtleitfaser (25B) sich außerhalb der isolierenden Säule (17) hinter dem Boden (18) befindet, der mit durchsichtigen Fenstern (40) versehen ist, und daß die Metallplatte (3) Öffnungen (35) aufweist.

## Claims

1. A high-tension circuit-breaker including, for each phase, at least one insulating case (1), which case is filled with a dielectric gas under pressure, and including fixed and moving main contacts (4, 6), fixed and moving arcing contacts (5, 7), and a drive rod (16), said insulating case (1) being placed on an insulating column (17), a metal plate (3) constituting a current terminal separating said case (1) from said insulating column (17), said insulating column (17) being closed by a bottom (18) disposed on a metal structure (19), said drive rod (16) passing through said plate (3) and said bottom (18), said circuit-breaker including a detector of the light flux emitted by arcs that occur in said case (1), said circuit-breaker being characterized in that the light flux detector includes a fluorescent fiber (25) which is disposed in the form of a symmetrical loop around the drive rod (16), each end of the fiber being connected to a photodiode (26, 27) equipped with an amplifier, said amplifiers having different sensitivities.

2. A circuit-breaker according to claim 1, characterized in that the loop (25) is disposed inside the insulating column (17), and the metal plate (3) is pierced with openings (35).

3. A circuit-breaker according to claim 2, characterized in that a second fluorescent or scintillating fiber (25A) is mounted symmetrically relative to the first fiber (25).

4. A circuit-breaker according to any one of claims 1 to 3, characterized in that the optical fiber (25) is placed inside a transparent tube (37) in which it is immersed in air.

5. A circuit-breaker according to claim 1, characterized in that said optical fiber (25B) is placed outside the insulating column (17), behind the bottom (18), which bottom is equipped with transparent ports (40), the metal plate (3) being pierced with openings (35).
